# FASCICULE DE BREVET EUROPEEN

(11) **EP 2 382 672 B1**
(45) Date de publication et mention de la délivrance du brevet: **07.11.2018**
(21) Numéro de dépôt: 10707586.3
(22) Date de dépôt: 26.01.2010
(51) Int. Cl.: H01L 31/107, H01L 31/0352, H01L 31/103, H01L 31/0296, H01L 31/0304, H01L 31/0216, H01L 31/0232

(54) **PROCÉDÉ DE FABRICATION D'UNE PHOTODIODE ET PHOTODIODE ET DÉTECTEUR DE RAYONNEMENT ELECTROMAGNÉTIQUE CORRESPONDANTS**
VERFAHREN ZUR HERSTELLUNG EINER PHOTODIODE UND ENTSPRECHENDE PHOTODIODE UND DETEKTOR FÜR ELECTROMAGNETISCHE STRAHLUNG
METHOD OF MAKING A PHOTODIODE AND CORRESPONDING PHOTODIODE AND ELECTROMAGNETIC RADIATION DETECTOR

(30) Priorité: 29.01.2009 FR 0950545
(43) Date de publication de la demande: 02.11.2011
(73) Titulaire: Commissariat à l'Énergie Atomique et aux Énergies Alternatives, 75015 Paris (FR)
(72) Inventeur: ROTHMAN, Johan, 38250 Lans En Vercors (FR)
(74) Mandataire: Cabinet Laurent & Charras
(86) Numéro de dépôt international: PCT/FR2010/050112
(87) Numéro de publication internationale: WO 2010/086543

(56) Documents cités:
- EP-A1- 1 903 612
- US-A- 5 747 864

## Description

### DOMAINE TECHNIQUE

L'invention se rapporte au domaine des photodiodes aptes à interagir avec des photons incidents, notamment lorsqu'elles fonctionnent sous une polarisation nulle ou inverse, et au domaine des détecteurs de rayonnements électromagnétiques.

### ETAT ANTERIEUR DE LA TECHNIQUE

Une photodiode est un composant semi-conducteur comprenant une jonction de type P-N et ayant notamment la capacité de détecter un rayonnement du domaine optique et de le transformer en signal électrique. On utilise par exemple des photodiodes en polarisation inverse pour la détection et la mesure de flux de photons incidents.

La polarisation inverse d'une photodiode permet en effet d'accélérer les porteurs de charge libres sous l'effet d'un champ électrique appliqué dans la zone de déplétion située entre des couches dopées de type N et des couches dopées de type P. Les porteurs de charge libres peuvent acquérir une énergie suffisante pour créer des paires électron-trou supplémentaires. Lorsque la polarisation inverse est suffisante, on obtient un effet d'avalanche, c'est-à-dire une multiplication du nombre de photoporteurs à partir d'un faible nombre de photoporteurs initiaux.

La photodiode dite à avalanche permet notamment une détection des flux de photons incidents de manière relativement sensible et rapide, et offre diverses possibilités d'applications, parmi lesquelles la réalisation de plans focaux de détection pour l'imagerie active, la détection rapide dans le domaine des télécommunications, la spectroscopie, la détection de flux lumineux très faible, voire le comptage de photons.

L'amélioration des paramètres de fonctionnement d'une photodiode à avalanche se traduit notamment par :
- une amplification des faibles courants ainsi qu'un faible facteur de bruit électronique pour garantir un bon rapport signal sur bruit ;
- une minimisation du courant d'obscurité qui traverse la photodiode à avalanche, et qui contribue à la dégradation du rapport signal sur bruit ;
- une augmentation du gain d'avalanche ; et
- une diminution de la tension de polarisation.

Il a été proposé dans le document EP 1 903 612, une photodiode ayant notamment l'avantage de présenter un courant d'obscurité relativement faible, ainsi qu'un gain élevé sous faible polarisation inverse sans dégradation du rapport signal sur bruit du détecteur qui la met en oeuvre, notamment lors de la détection de rayonnements infrarouges. Cette photodiode comprend un empilement de couches semi-conductrices d'un premier type de conductivité, et une région s'étendant transversalement par rapport aux plans des couches et présentant un type de conductivité opposé au premier type de conductivité de façon à former une jonction P-N avec l'empilement.

Cependant, cette photodiode de l'art antérieur ne présente pas des performances optimales. En effet, malgré une sensibilité et un temps de réponse acceptables, il peut être nécessaire de prévoir un refroidissement de la photodiode, notamment lors de son utilisation à haute température, du fait du dopage extrinsèque des couches de l'empilement. En outre, le courant d'obscurité est d'autant plus grand que la température de fonctionnement de la photodiode est élevée, et limitant de ce fait la sensibilité de la photodiode en fonctionnement à haute température.

Par ailleurs, dans la mesure où il est difficile d'atteindre une pureté parfaite dans les cristaux, un matériau semi-conducteur dopé contient non seulement des dopants extrinsèques, c'est-à-dire qui sont liés à des impuretés incorporées intentionnellement, mais également des dopants résiduels qui sont liés à des défauts intrinsèques, par exemple structurels ou des impuretés chimiques que l'on ne peut pas supprimer lors de la fabrication du matériau. La présence de ces deux types de défauts induit des recombinaisons dans les matériaux, diminue la durée de vie des porteurs minoritaires déjà limitée par l'existence de l'effet Auger, et contribue au courant d'obscurité notamment lorsque la photodiode est utilisée à haute température.

Le document US5747864 A divulgue un dispositif photosensible comprenant au moins deux jonctions p-n séparées par une couche légèrement dopée ou intrinsèque.

Dans ce contexte, la présente invention a pour but de proposer une photodiode exempte de l'une au moins des limitations précédemment évoquées. Plus particulièrement, la présente invention a pour but d'améliorer les performances de la photodiode de l'art antérieur, et notamment de proposer une photodiode apte à capter des rayonnements infrarouges à haute température.

### EXPOSE DE L'INVENTION

L'invention concerne à cet effet un procédé de fabrication d'une photodiode selon la revendication 1.

Selon l'invention :
- la couche intermédiaire est réalisée en un matériau semi-conducteur selon le deuxième type de conductivité ; et
- l'épaisseur de la couche intermédiaire et les concentrations en dopants des première et deuxième couches et de la couche intermédiaire sont sélectionnées de manière à obtenir une inversion du type de conductivité de la couche intermédiaire, depuis le deuxième type de conductivité vers le premier type de conductivité, par les dopants de premier type de conductivité présents dans les première et deuxième couches.

Par exemple, le premier type de conductivité est de type P et le deuxième type de conductivité est de type N.

En d'autres termes, la présence des porteurs de charge de premier type dans la couche intermédiaire est uniquement induite par les dopants de premier type de conductivité présents dans les première et deuxième couches, notamment lorsque la photodiode est soumise à une polarisation nulle ou inverse. La couche intermédiaire de la photodiode subit donc un dopage modulé ou une inversion de son type de conductivité, c'est-à-dire que la couche intermédiaire réalisée dans un semi-conducteur du deuxième type de conductivité, présente non plus une conductivité du deuxième type mais une conductivité du premier type. Par ailleurs, le dopage modulé a notamment l'avantage d'augmenter la mobilité des porteurs de charge, et donc la sensibilité de la photodiode.

Selon une forme de réalisation de l'invention, ladite région s'étend partiellement dans la couche d'interaction, constituée notamment de ladite première couche.

Les première et deuxième couches peuvent être réalisées en des matériaux semi-conducteurs extrinsèques du premier type de conductivité, c'est-à-dire contenant des dopants de premier type de conductivité intentionnellement incorporés.

La couche intermédiaire peut être réalisée en un semi-conducteur extrinsèque dopé avec des dopants de deuxième type de conductivité.

La couche intermédiaire peut également être réalisée en un matériau semi-conducteur non intentionnellement dopé, comprenant des dopants résiduels de deuxième type de conductivité.

Préférentiellement, la concentration de dopants de deuxième type de la couche intermédiaire, avant le dopage par modulation, est inférieure à la concentration de dopants des première et deuxième couches.

Les dopants résiduels sont liés à des défauts intrinsèques ou à des impuretés qu'on ne peut pas supprimer lors de la fabrication du matériau semi-conducteur. Un semi-conducteur extrinsèque, donc intentionnellement dopé, peut donc contenir des défauts intrinsèques liés aux dopants résiduels et des défauts extrinsèques liés aux dopants intentionnellement incorporés. L'utilisation d'un semi-conducteur non intentionnellement dopé pour la couche intermédiaire associée au dopage modulé permet donc de doper la couche intermédiaire avec des porteurs de charge de premier type de conductivité sans les défauts extrinsèques dus au dopage intentionnel. La couche intermédiaire peut ainsi être dopée avec des dopants de premier type de conductivité sans être sensible aux défauts liés à un dopage extrinsèque.

Avantageusement, la couche intermédiaire présente une épaisseur inférieure aux épaisseurs respectives des première et deuxième couches.

La faible épaisseur de la couche intermédiaire permet de faciliter son dopage modulé, c'est-à-dire le transfert des porteurs libres (notamment des dopants de premier type de conductivité) des première et deuxième couches dans la couche intermédiaire, pour engendrer une inversion du type de conductivité de la couche intermédiaire. Une jonction P-N peut ainsi être formée notamment quand une différence de potentiel nulle est appliquée entre l'anode et la cathode, l'anode étant par exemple formée par un matériau électriquement conducteur en contact avec la première couche et/ou la deuxième couche, et la cathode étant par exemple formée par un autre matériau électriquement conducteur en contact avec ladite région. Par ailleurs, la faible épaisseur de la couche intermédiaire permet également de limiter le courant d'obscurité et l'interaction des rayonnements perturbateurs.

Selon un autre mode de réalisation, les matériaux semi-conducteur utilisés pour former les trois couches de l'empilement peuvent être des alliages de cadmium (Cd), de mercure (Hg) et de tellure (Te), de formule générale CdₓHg₁₋ₓTe, où x est une valeur comprise entre 0 et 1 représentant la fraction molaire de cadmium dans la composition de l'alliage.Un tel alliage permet de réaliser une photodiode à faible facteur de bruit et à faible courant d'obscurité pour un gain de multiplication important à faible polarisation.

Les première et deuxième couches peuvent présenter chacune :
- une concentration en dopants de premier type de conductivité comprise entre 10¹⁵ cm⁻³ et 10¹⁷ cm⁻³ ;
- une épaisseur comprise entre 0,5 et 2 micromètres ; et
- une fraction molaire x comprise entre 0,3 et 0,8.

La couche intermédiaire peut présenter :
- une concentration en dopants de deuxième type de conductivité comprise entre 10¹⁴ cm⁻³ et 10¹⁵ cm⁻³ ;
- une épaisseur comprise entre 0,1 et 1 micromètre ; et
- une fraction molaire x comprise entre 0,1 et 0,5, de préférence entre 0,2 et 0,3.

Des matériaux semi-conducteurs constitués d'alliages d'éléments appartenant aux colonnes III et IV du tableau de Mendeleïev, par exemple un alliage d'indium (In) et d'antimoine (Sb), de formule générale InSb, peuvent également être utilisés pour former les trois couches de l'empilement.

Les matériaux semi-conducteurs utilisés pour former les trois couches de l'empilement peuvent également être des super-réseaux de type 2 à base de semi-conducteurs des colonnes III et V du tableau de Mendeleïev. Les super-réseaux de type 2 à base de semi-conducteurs III et V sont des hétéro-structure en super-réseaux avec des puits quantiques alternés pour des trous et des électrons, permettant de créer une faible bande interdite par le couplage et de réaliser un matériau qui coupe par exemple à 10µm à partir de matériaux ayant des bandes interdites proches de 1µm, comme décrit dans la publication intitulée « Recent advances in LWIR Type - II InAs/GaSb superlattice photodetectors and focal plane arrays at the Center for Quantum Devices » paru dans Proc. SPIE (vol. 6940 pages 1 à 12).

L'invention a également pour objet une photodiode selon la revendication 6.

Selon un mode de réalisation particulier de la photodiode selon l'invention :
- la première couche peut être une couche d'interaction destinée à interagir avec les photons incidents de façon à générer des photoporteurs ;
- la couche intermédiaire peut être une couche de collecte des photoporteurs, et peut présenter une largeur de bande interdite inférieure au double des largeurs de bande interdite respectives des première et deuxième couches ; et
- la deuxième couche peut être une couche de confinement destinée à confiner les photoporteurs au niveau de la couche de collecte.

Selon un autre mode de réalisation de la photodiode selon l'invention :
- la couche intermédiaire peut être à la fois une couche d'interaction destinée à interagir avec les photons incidents de façon à générer des photoporteurs, et une couche de collecte des photoporteurs, la couche intermédiaire pouvant présenter une largeur de bande interdite inférieure aux largeurs de bande interdite respectives des première et deuxième couches ; et
- les première et deuxième couches peuvent être des couches de confinement destinées à confiner les photoporteurs dans la couche de collecte.

Dans le mode de réalisation précité, le courant d'obscurité est diminué, ainsi que le rendement quantique (c'est-à-dire le ratio des photons absorbés sur les photons incidents sur le photodétecteur). Cependant, le courant d'obscurité est suffisamment faible pour justifier la perte du rendement quantique, et permet ainsi d'améliorer la sensibilité de la structure.

Le dopage modulé entraîne une concentration de porteurs de charge de premier type de conductivité dans la couche intermédiaire qui est plus faible que la concentration de porteurs de charge de premier type de conductivité des première et deuxième couches. De ce fait, la zone de déplétion dans la couche intermédiaire est plus étendue que la zone de déplétion dans les première et deuxième couches. Ceci permet d'augmenter le confinement de porteur dans la région d'avalanche.

Pour améliorer la sensibilité de la photodiode, il est possible d'intégrer une cavité résonnante formée de première et deuxième surfaces réfléchissantes placées respectivement de part et d'autre de l'empilement.

En d'autres termes, les première et deuxième surfaces réfléchissantes sont placées respectivement sur les faces avant et arrière de la structure.

La première surface réfléchissante peut être un miroir métallique et la deuxième surface réfléchissante peut être un miroir de Bragg.

Par ailleurs, les épaisseurs respectives des première et deuxième couches, ainsi que l'épaisseur de la région peuvent être ajustées pour maximiser l'absorption dans la couche intermédiaire dans une gamme de longueurs d'ondes précise, et améliorer ainsi la sensibilité de la photodiode.

En pratique, la couche de confinement peut être recouverte d'une couche de passivation.

Avantageusement, un plot de lecture est réalisé de telle sorte à être en contact avec ladite région, et destiné à transmettre les signaux électriques formés par les photoporteurs à un circuit d'exploitation.

L'invention concerne également un détecteur de rayonnement électromagnétique comprenant au moins une photodiode telle que décrite ci-dessus.

Ainsi, l'invention permet notamment de réaliser une photodiode apte à capter des rayonnements infrarouge et à fonctionner dans des conditions de haute température, et typiquement, à une température supérieure à 200 K pour une longueur d'onde de coupure de 5 µm.

### BREVE DESCRIPTION DES DESSINS

D'autres caractéristiques et avantages de l'invention ressortiront clairement de la description qui en est faite ci-après, à titre indicatif et nullement limitatif, en référence aux dessins annexés, dans lesquels :
- la figure 1 est une représentation schématique en section d'une photodiode conforme à une réalisation particulière de l'invention ;
- la figure 2 est une représentation schématique en section d'une photodiode selon la figure 1, et sur la gauche de la figure 2, on a représenté le diagramme des largeurs des bandes interdites des différentes couches constituants cette photodiode ;
- la figure 3 est une représentation schématique en section d'une photodiode selon la figure 1, et sur la gauche de la figure 3, on a représenté le diagramme des concentrations en dopants dans les différentes couches constituants cette photodiode ;
- la figure 4 est une représentation schématique en section d'une photodiode selon la figure 1 sous une polarisation nulle, et sur la gauche de la figure 4, on a représenté le diagramme de concentration de trous dans les couches de l'empilement, et sur la droite de la figure 4, on a représenté le diagramme de concentration en trous dans la jonction P-N ; et
- la figure 5 est une représentation schématique en section d'une photodiode selon un autre mode de réalisation particulière de l'invention.

### EXPOSE DETAILLE DE MODES DE REALISATION PARTICULIER

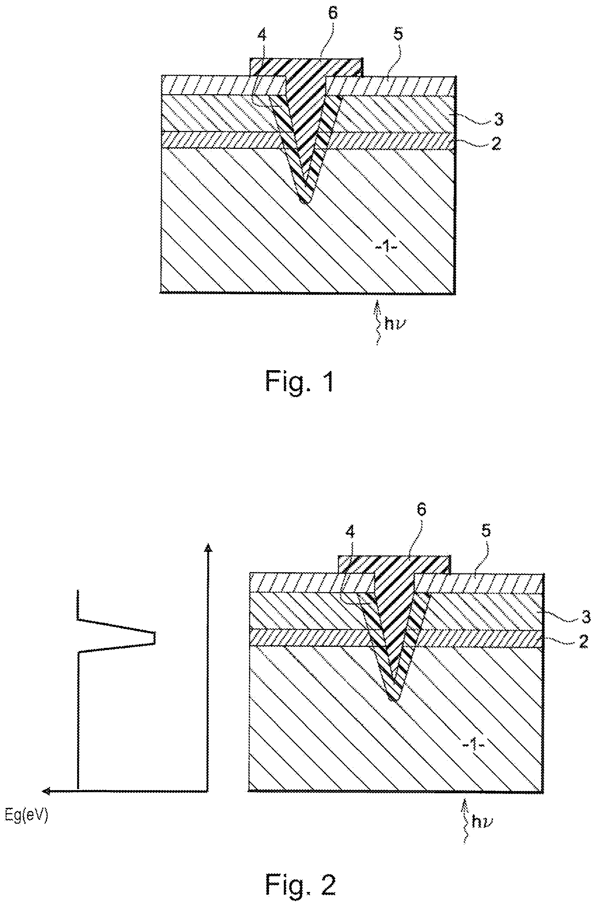

La figure 1 illustre une photodiode conforme à un mode de réalisation particulier de l'invention. Celle-ci comprend :
- un empilement de trois couches, ledit empilement comprenant une couche intermédiaire **2** interposée entre des première et deuxième couches **1, 3** de semi-conducteurs d'un premier type de conductivité ; et
- une région **4** s'étendant transversalement par rapport aux plans des trois couches **1, 2, 3,** en contact avec au moins la couche intermédiaire **2** et la deuxième couche **3,** et présentant un type de conductivité opposé au premier type de conductivité.

La couche intermédiaire **2** est réalisée en un semi-conducteur d'un deuxième type de conductivité, et est apte à présenter un type de conductivité opposé au deuxième type de conductivité, de façon à former une jonction P-N avec ladite région **4,** l'inversion du type de conductivité de la couche intermédiaire **2** étant induite par les dopants de premier type de conductivité présents dans les première et deuxième couches **1, 3.**

La concentration de dopants de la couche **2** est inférieure à la concentration de dopants des couches **1** et **3** pour avoir un effet de modulation.

Les matériaux semi-conducteurs utilisés pour former les trois couches **1, 2, 3** de l'empilement peuvent être des alliages de cadmium (Cd), de mercure (Hg) et de tellure (Te), de formule générale CdₓHg₁₋ₓTe, où x est une valeur comprise entre 0 et 1 et représente la fraction molaire de cadmium dans la composition de l'alliage. Un tel alliage permet de réaliser une photodiode à faible facteur de bruit et à faible courant d'obscurité pour un gain de multiplication important à faible polarisation. L'épaisseur de la couche d'interaction **1** est choisie en fonction de la longueur d'onde du rayonnement à détecter.

Les première et deuxième couches **1, 3** sont réalisées en des matériaux semi-conducteurs extrinsèques présentant chacun :
- une concentration en dopants de premier type de conductivité comprise entre 10¹⁵ cm⁻³ et 10¹⁷ cm⁻³ ;
- une épaisseur comprise entre 0,5 et 2 micromètres ; et
- une fraction molaire x comprise entre 0,3 et 0,8.

La couche intermédiaire **2** est réalisée en un matériau semi-conducteur non intentionnellement dopé présentant :
- une concentration en dopants de deuxième type de conductivité comprise entre 10¹⁴cm⁻³ et 10¹⁵ cm⁻³ ;
- une épaisseur comprise entre 0,1 et 1 micromètre ; et
- une fraction molaire x comprise entre 0,1 et 0, 5, de préférence entre 0,2 et 0,3.

En pratique, le premier type de conductivité est de type P et le deuxième type de conductivité est de type N. Ainsi, la conductivité de la couche intermédiaire **2** réalisée dans un semi-conducteur non intentionnellement dopé est de type N, alors que les conductivités respectives des première et deuxième couches **1, 3** réalisées dans des semi-conducteurs intentionnellement dopés est de type P.

Les opérations de réalisation de la région **4** sont réalisées de manière conventionnelle et sa forme est déterminée en fonction de la superficie de l'interface de jonction P-N nécessaire à la collecte des photoporteurs. En outre, la région **4** ne pénètre pas nécessairement au sein de la première couche **1.** Cependant, en raison des contraintes nées des techniques de réalisation, la région **4** peut pénétrer légèrement ladite première couche **1,** afin d'être certain que ladite région **4** traverse la couche intermédiaire **2.**

Selon ce mode de réalisation particulier, la première couche **1** joue le rôle de couche d'interaction et est destinée à interagir avec des photons incidents d'un rayonnement électromagnétique, tel que les rayons infrarouges. Cette première couche **1** s'étend donc de préférence transversalement, voire perpendiculairement, à la direction des photons incidents à détecter. La couche intermédiaire **2** joue le rôle de couche de collecte des photoporteurs et présente une largeur de bande interdite (communément appelée « gap ») inférieure au double des largeurs de bande interdite respectives des première et deuxième couches **1, 3,** comme illustré sur la figure 2. Ce faisant, on assure un confinement des porteurs de charge, qui acquièrent l'énergie nécessaire pour produire une ionisation par impact, responsable de la multiplication.

La deuxième couche **3** joue le rôle de couche de confinement et est destinée à confiner les photoporteurs au niveau de la couche de collecte.

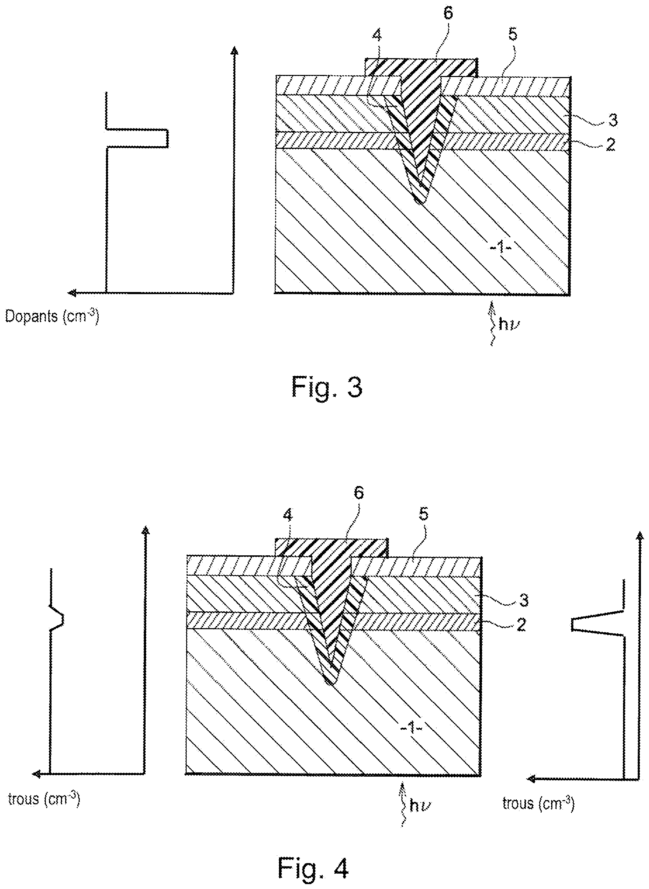

La couche intermédiaire **2** présente de préférence une épaisseur inférieure aux épaisseurs respectives des première et deuxième couches **1, 3.** La faible épaisseur de la couche intermédiaire **2** permet de faciliter le dopage modulé de ladite couche intermédiaire **2,** c'est-à-dire le transfert des porteurs libres (notamment des dopants de premier type de conductivité (ici les trous)) des première et deuxième couches **1, 3** dans la couche intermédiaire **2,** pour engendrer une inversion du type de conductivité de la couche intermédiaire **2,** comme illustré sur la figure 3. Une jonction P-N peut ainsi être formée notamment quand une différence de potentiel nulle est appliquée entre l'anode et la cathode, l'anode étant par exemple formée par un matériau électriquement conducteur en contact avec la première couche **1** et/ou la deuxième couche **3,** et la cathode étant par exemple formée par un autre matériau électriquement conducteur en contact avec la région **4.** Par ailleurs, la faible épaisseur de la couche intermédiaire permet également de limiter le courant d'obscurité et de réduire l'interaction des rayonnements perturbateurs.

La concentration en dopants de deuxième type de conductivité (ici type N) dans la couche intermédiaire **2** est appelé dopage résiduel, et est liée à des défauts intrinsèques ou impuretés qu'il est difficile de supprimer lors de la fabrication du matériau. Ce dopage résiduel est donc toujours présent. Le dopage par modulation appliqué à la couche intermédiaire **2** permet ainsi d'inverser la conductivité de la couche intermédiaire **2** et de conférer à la couche intermédiaire **2** initialement de type N, une conductivité de type P sans les défauts associés à un dopage extrinsèque. Le dopage de la couche intermédiaire **2** est induit par les dopants présents dans les première et deuxième couches **1, 3.**

Comme illustré sur la figure 3, la concentration en dopants de deuxième type de conductivité dans la couche intermédiaire **2** est choisie inférieure aux concentrations en dopants de premier type de conductivité dans les première et deuxième couches respectivement **1, 3.** De ce fait, la zone de déplétion dans la couche intermédiaire **2** est rendue plus étendue que les zones de déplétion dans les première et deuxième couches **1, 3,** et le gain d'avalanche ainsi que le confinement des photoporteurs dans la couche intermédiaire **2** sont augmentés. Par ailleurs, quand la photodiode est polarisée en inverse, le nombre de porteurs minoritaire se réduit, et engendre une suppression de l'effet dit « de génération Auger ». Ainsi, le courant d'obscurité généré en dehors de la zone de déplétion va aussi être réduit quand le dispositif est utilisé à haute température de fonctionnement. Le rendement quantique est également diminué. Cependant, le courant d'obscurité est suffisamment faible pour justifier la perte du rendement quantique, et permet ainsi d'améliorer la sensibilité de la structure.

Le dopage modulé entraîne une concentration de porteurs de charge de premier type de conductivité dans la couche intermédiaire qui est plus faible que la concentration de porteurs de charge de premier type de conductivité des première et deuxième couches. De ce fait, la zone de déplétion dans la couche intermédiaire est plus étendue que la zone de déplétion dans les première et deuxième couches. Ceci permet d'augmenter le confinement de porteur dans la région d'avalanche.

En pratique, la deuxième couche **3,** jouant le rôle de couche de confinement, peut être recouverte d'une couche de passivation **5** qui est électriquement neutre. Cette couche de passivation est réalisée en un matériau isolant, tel que par exemple en ZnS. La région **4** est mise en contact avec un matériau électriquement conducteur destiné à former un plot **6,** par exemple de lecture, pour transmettre les signaux électriques formés par les photoporteurs collectés au niveau de la jonction P-N vers le circuit d'exploitation du détecteur (non représenté). Le matériau constitutif du plot de lecture **6** est en contact électrique avec le matériau formant la région **4,** tandis qu'il est isolé de la couche de confinement **3** par la couche de passivation **5.**

Ainsi, les photoporteurs libérés par les interactions entre les rayons incidents et la couche d'interaction (ici la première couche **1**), subissent une multiplication par effet d'avalanche, en raison de l'étroitesse de la bande interdite de la couche de collecte (ici la couche intermédiaire **2**). En effet, sous la même tension de polarisation inverse, la multiplication de photoporteurs dans les zones de déplétion des jonctions P-N situées entre la région **4** et chacune des première et deuxième couches **1, 3** s'avère négligeable du fait de la largeur plus importante de la bande interdite de ces couches. Par conséquent, la multiplication des photoporteurs est réalisée majoritairement par la jonction P-N située entre la région **4** et la couche de collecte (ici la couche intermédiaire **2**). Par ailleurs, la zone de déplétion de la couche intermédiaire étant plus étendue, le confinement des porteurs dans la couche intermédiaire **2** est accentué, et va réduire la probabilité que les porteurs s'échappent de la couche intermédiaire, améliorant ainsi le gain de la structure.

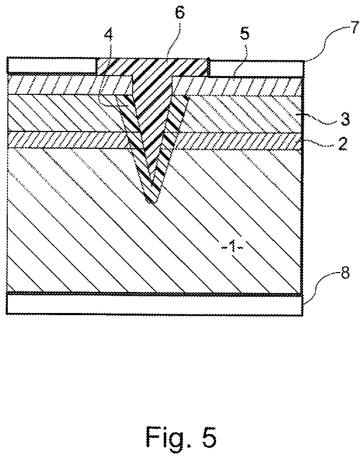

Pour améliorer la sensibilité de la photodiode, il est possible d'intégrer une cavité résonnante formée de première et deuxième surfaces réfléchissantes **7, 8** placées respectivement de part et d'autre de l'empilement, c'est-à-dire sur les faces avant et arrière de la photodiode, comme illustré sur la figure 5. La première surface réfléchissante **7** peut être un miroir métallique, et la deuxième surface réfléchissante **8** peut être un miroir de Bragg, les faces réfléchissantes des deux miroirs étant placées face à face.

Des matériaux semi-conducteurs constitués d'alliages d'éléments appartenant aux colonnes III et IV du tableau de Mendeleïev, par exemple un alliage d'indium (In) et d'antimoine (Sb), de formule générale InSb, peuvent également être utilisés pour former les trois couches de l'empilement.

Les matériaux semi-conducteurs utilisés pour former les trois couches de l'empilement peuvent également être des super-réseaux de type 2 à base de semi-conducteurs des colonnes III et V du tableau de Mendeleïev. Les super-réseaux de type 2 à base de semi-conducteurs III et V sont des hétéro-structure en super-réseaux avec des puits quantiques alternés pour des trous et des électrons, permettant de créer une faible bande interdite par le couplage des états des trous et des électrons confinés dans chaque puits. Il est ainsi possible de faire un matériau qui coupe par exemple à 10µm à partir de matériaux ayant des bandes interdites proches de 1µm, comme décrit dans la publication intitulée « Recent advances in LWIR Type - II InAs/GaSb superlattice photodetectors and focal plane arrays at the Center for Quantum Devices » paru dans Proc. SPIE (vol. 6940 pages 1 à 12).

Selon un autre mode de réalisation de l'invention :
- la couche intermédiaire peut être à la fois une couche d'interaction destinée à interagir avec les photons incidents de façon à générer des photoporteurs, et une couche de collecte des photoporteurs, la couche intermédiaire pouvant présenter une largeur de bande interdite inférieure aux largeurs de bande interdite respectives des première et deuxième couches ; et
- les première et deuxième couches peuvent être des couches de confinement destinées à confiner les photoporteurs dans la couche de collecte.

Dans ce mode de réalisation, la détection du rayonnement se fait dans la couche intermédiaire. Avec une telle structure, le courant d'obscurité est diminué, ainsi que le rendement quantique (c'est-à-dire le ratio des photons absorbés sur les photons incidents sur le photodétecteur). Cependant, à cause notamment de la suppression de l'effet Auger, la réduction du courant d'obscurité est plus importante que la réduction du rendement quantique, améliorant de ce fait la sensibilité de la structure.

La photodiode décrite ci-dessus peut être utilisée pour capter des rayonnements infrarouges et pour fonctionner à haute température. La photodiode peut fonctionner comme capteur unique ou former un capteur élémentaire au sein d'une matrice de détection dans un détecteur.

## Revendications

1. Procédé de fabrication d'une photodiode apte à interagir avec des photons incidents, comprenant au moins :
- la réalisation d'un empilement de trois couches de semi-conducteurs définissant chacune un volume semi-conducteur et comprenant une couche intermédiaire (2) interposée entre une première couche inférieure (1) et une deuxième couche supérieure (3), les trois couches (1, 2, 3) présentant un premier type de conductivité ;
- la réalisation d'une région (4) semi-conductrice traversant le volume de la deuxième couche supérieure (3) et traversant au moins partiellement le volume de la couche intermédiaire (2), et s'étendant transversalement par rapport aux plans des trois couches (1, 2, 3), ladite région (4) présentant un deuxième type de conductivité opposé au premier type de conductivité de façon à former une jonction P-N avec la couche intermédiaire (2) ; et
- la réalisation d'un plot de lecture (6) en matériau électriquement conducteur au contact de la région (4) semi-conductrice ;
***caractérisé :***
- **en ce que** la couche intermédiaire (2) est réalisée en un matériau semi-conducteur selon le deuxième type de conductivité ;
- et **en ce que** l'épaisseur de la couche intermédiaire (2) et les concentrations en dopants des première et deuxième couches (1, 2, 3) et de la couche intermédiaire (2) sont tels qu'une inversion du type de conductivité de la couche intermédiaire (2) est obtenue depuis le deuxième type de conductivité vers le premier type de conductivité, par les dopants de premier type de conductivité présents dans les première et deuxième couches (1, 3).

2. Procédé de fabrication d'une photodiode selon la revendication 1, ***caractérisé* en ce que** la couche intermédiaire (2) présente une épaisseur inférieure aux épaisseurs respectives des première et deuxième couches (1, 3).

3. Procédé de fabrication d'une photodiode selon l'une des revendications 1 et 2, ***caractérisé* en ce que** la concentration en dopants de deuxième type de conductivité dans la couche intermédiaire (2) est inférieure aux concentrations en dopants de premier type de conductivité dans les première et deuxième couches (1, 3) respectivement.

4. Procédé de fabrication d'une photodiode selon l'une des revendications 1 à 3, ***caractérisé* en ce que** les matériaux semi-conducteurs mis en oeuvre pour former les trois couches (1, 2, 3) de l'empilement sont des alliages de cadmium, de mercure et de tellure, de formule générale CdₓHg₍₁₋ₓ₎Te, où x est une valeur comprise entre 0 et 1 représentant la fraction molaire de cadmium dans la composition de l'alliage.

5. Procédé de fabrication d'une photodiode selon la revendication 4, ***caractérisé* en ce que** les première et deuxième couches (1, 3) présentent chacune :
- une concentration en dopants de premier type de conductivité comprise entre 10¹⁵ cm⁻³ et 10¹⁷ cm⁻³ ;
- une épaisseur comprise entre 0,5 µm et 2 µm ; et
- une fraction molaire x comprise entre 0,3 et 0,8 ;
et **en ce que** la couche intermédiaire (2) présente :
- une concentration en dopants de deuxième type de conductivité comprise entre 10¹⁴ cm⁻³ et 10¹⁵ cm⁻³ ;
- une épaisseur comprise entre 0,1 µm et 1 µm ; et
- une fraction molaire x comprise entre 0,1 et 0,5, de préférence entre 0,2 et 0,3.

6. Photodiode apte à interagir avec des photons incidents, comprenant au moins :
- un empilement de trois couches de semi-conducteurs définissant chacune un volume semi-conducteur et comprenant une couche intermédiaire (2) interposée entre une première couche inférieure (1) et une deuxième couche supérieure (3), les trois couches (1, 2, 3) présentant un premier type de conductivité ;
- une région (4) semi-conductrice traversant le volume de la deuxième couche supérieure (3) et traversant au moins partiellement le volume de la couche intermédiaire (2), et s'étendant transversalement par rapport aux plans des trois couches (1, 2, 3), ladite région (4) présentant un deuxième type de conductivité opposé au premier type de conductivité de façon à former une jonction P-N avec la couche intermédiaire (2) ; et
- d'un plot de lecture (6) en matériau électriquement conducteur au contact de la région (4) semi-conductrice,
***caractérisée :***
- **en ce que** une concentration de porteur de charge de premier type de conductivité dans la couche intermédiaire (2) est inférieure à la concentration de porteurs de charge de premier type de conductivité dans les première et deuxième couches (1, 3).

7. Photodiode selon la revendication 6, ***caractérisée :***
- **en ce que** la première couche (1) est une couche d'interaction destinée à interagir avec les photons incidents de façon à générer des photoporteurs ;
- **en ce que** la couche intermédiaire (2) est une couche de collecte des photoporteurs, et présente une largeur de bande interdite inférieure à chacune des largeurs de bande interdite respectives des première et deuxième couches (1, 3) ;
- et **en ce que** la deuxième couche (3) est une couche de confinement destinée à confiner les photoporteurs au niveau de la couche de collecte.

8. Photodiode selon l'une des revendications 6 et 7, ***caractérisée :***
- **en ce que** la couche intermédiaire (2) est à la fois une couche d'interaction destinée à interagir avec les photons incidents de façon à générer des photoporteurs, et une couche de collecte des photoporteurs, ladite couche intermédiaire (2) présentant une largeur de bande interdite inférieure à chacune des largeurs de bande interdite respectives des première et deuxième couches (1, 3) ;
- et **en ce que** les première et deuxième couches (1, 3) sont des couches de confinement destinées à confiner les photoporteurs dans la couche de collecte.

9. Photodiode selon l'une des revendications 6 à 8, ***caractérisée* en ce qu'**elle comprend en outre une cavité résonnante formée d'une première et d'une deuxième surfaces réfléchissantes (7, 8) placées respectivement de part et d'autre de l'empilement.

10. Photodiode selon la revendication 9, ***caractérisée* en ce que** la première surface réfléchissante (7) est un miroir métallique et **en ce que** la deuxième surface réfléchissante (8) est un miroir de Bragg.

11. Photodiode selon l'une des revendications 6 à 9, ***caractérisée* en ce que** ladite région (4) s'étend partiellement dans la première couche inférieure (1).

12. Photodiode selon l'une des revendications 6 à 10, ***caractérisée* en ce que** la deuxième couche (3) est recouverte d'une couche de passivation (5).

13. Détecteur de rayonnement électromagnétique comprenant au moins une photodiode selon l'une des revendications 6 à 12.

## Patentansprüche

1. Verfahren zur Herstellung einer Photodiode, die in der Lage ist, mit einfallenden Photonen zu interagieren, mindestens umfassend:
- die Herstellung eines Stapels aus drei Schichten Halbleitern, die jeweils ein Halbleitervolumen definieren und eine Zwischenschicht (2) enthalten, die zwischen einer ersten unteren Schicht (1) und einer zweiten oberen Schicht (3) angeordnet ist, wobei die drei Schichten (1, 2, 3) einen ersten Leitfähigkeitstyp aufweisen;
- die Ausführung eines Halbleiterbereichs (4), der durch das Volumen der zweiten oberen Schicht (3) hindurchführt und zumindest teilweise durch das Volumen der Zwischenschicht (2) hindurchführt, und dabei quer zu den Ebenen der drei Schichten (1, 2, 3) verläuft, dieser Bereich (4) weist einen zweiten Leitfähigkeitstyp auf, entgegengesetzt zum ersten Leitfähigkeitstyp, so dass ein P-N- Übergang zur Zwischenschicht (2) gebildet ist; und
- die Herstellung eines Readers (6) aus elektrisch leitendem Material, in Kontakt mit dem Halbleiterbereich (4);
**dadurch gekennzeichnet, dass**:
- die Zwischenschicht (2) aus einem Halbleitermaterial mit dem zweiten Leitfähigkeitstyp hergestellt ist;
- und dadurch, dass die Dicke der Zwischenschicht (2) und die Konzentrationen an Dotierstoffen der ersten und zweiten Schicht (1, 2, 3) und der Zwischenschicht (2) so geartet sind, dass durch Dotierstoffe des ersten Leitfähigkeitstyps, die in der ersten und zweiten Schicht (1, 3) vorhanden sind, eine Umkehrung des Leitfähigkeitstyps der Zwischenschicht (2) vom zweiten Leitfähigkeitstyp hin zum ersten Leitfähigkeitstyp erreicht wird

2. Verfahren zur Herstellung einer Fotodiode nach Anspruch 1 **dadurch gekennzeichnet, dass** die Zwischenschicht (2) eine Dicke aufweist, die geringer ist als die jeweilige Dicke der ersten und zweiten Schicht (1, 3)

3. Verfahren zur Herstellung einer Fotodiode nach irgendeinem der Ansprüche 1 und 2, **dadurch gekennzeichnet, dass** die Konzentration an Dotierstoffen des zweiten Leitfähigkeitstyps in der Zwischenschicht (2) niedriger sind, als die Konzentrationen an Dotierstoffen des ersten Leitfähigkeitstyps jeweils in der ersten und zweiten Schicht (1, 3).

4. Verfahren zur Herstellung einer Fotodiode nach irgendeinem der Ansprüche 1 bis 3, **dadurch gekennzeichnet, dass** die Halbleitermaterialien, die eingesetzt werden, um die drei Schichten (1, 2, 3) des Stapels zu bilden, Cadmium-, Quecksilber- und Tellurverbindungen, mit der allgemeinen Formel CdₓHg_{(1-X)}Te sind, worin x ein Wert zwischen 0 und 1 ist, der den Cadmium-Molenbruch in der Verbindung der Legierung darstellt.

5. Verfahren zur Herstellung einer Fotodiode nach Anspruche 4, **dadurch gekennzeichnet, dass** die erste und zweite Schicht (1, 3) jeweils aufweisen:
- eine Konzentration an Dotierstoffen des ersten Leitfähigkeitstyps zwischen 10¹⁵ cm⁻³ und 10¹⁷ cm⁻³;
- eine Dicke zwischen 0,5 µm et 2 µm; und
- einen Molenbruch x zwischen 0,3 und 0,8;
und dadurch, dass die Zwischenschicht (2) aufweist:
- eine Konzentration an Dotierstoffen des zweiten Leitfähigkeitstyps zwischen 10¹⁴ cm⁻³ und 10¹⁵ cm⁻³ ;
- eine Dicke zwischen 0,1 µm et 1 µm ; und
- einen Molenbruch x zwischen 0,1 und 0,5; besser zwischen 0,2 und 0,3.

6. Photodiode, die in der Lage ist, mit einfallenden Photonen zu interagieren, mindestens umfassend:
- einen Stapel aus drei Schichten Halbleitern, die jeweils ein Halbleitervolumen definieren und eine Zwischenschicht (2) enthalten, die zwischen einer ersten unteren Schicht (1) und einer zweiten oberen Schicht (3) angeordnet ist, wobei die drei Schichten (1, 2, 3) einen ersten Leitfähigkeitstyp aufweisen;
- einen Halbleiterbereich (4), der durch das Volumen der zweiten oberen Schicht (3) hindurchführt und zumindest teilweise durch das Volumen der Zwischenschicht (2) hindurchführt, und dabei quer zu den Ebenen der drei Schichten (1, 2, 3) verläuft, dieser Bereich (4) weist einen zweiten Leitfähigkeitstyp auf, entgegengesetzt zum ersten Leitfähigkeitstyp, so dass ein P-N- Übergang zur Zwischenschicht (2) gebildet ist; und
- einen Reader (6) aus elektrisch leitendem Material, in Kontakt mit dem Halbleiterbereich (4),
**dadurch gekennzeichnet, dass**
- die Konzentration an Ladungsträger des ersten Leitfähigkeitstyps in der Zwischenschicht (2) niedriger ist als die Konzentration an Ladungsträgern des ersten Leitfähigkeitstyps in der ersten und zweiten Schicht (1, 3).

7. Fotodiode nach Anspruch 1 **dadurch gekennzeichnet,**
- **dass** es sich bei der ersten Schicht (1) um eine Interaktionsschicht handelt, die mit den einfallenden Photonen interagiert und so Fototräger erzeugt;
- **dass** es sich bei der Zwischenschicht (2) um eine Fototräger- Sammelschicht handelt, die eine Bandlücke aufweist, die kleiner ist als die jeweilige Bandlücke der ersten und zweiten Schicht (1, 3);
- und **dass** es sich bei der zweiten Schicht (3) um eine Mantelschicht handelt, die die Fototräger innerhalb der Sammelschicht halten soll.

8. Fotodiode nach irgendeinem der Ansprüche 6 bis 7 **dadurch gekennzeichnet, dass**:
- die Zwischenschicht (2) gleichzeitig eine Interaktionsschicht ist, die mit den einfallenden Photonen interagieren soll, um so Fototräger zu erzeugen und eine Sammelschicht für die Fototräger, diese Zwischenschicht (2) weist eine Bandlücke auf, die kleiner ist als die jeweilige Bandlücke der ersten und zweiten Schicht (1, 3);
- und dass es sich bei der ersten und zweiten Schicht (1, 3) um Mantelschichten handelt, die die Fototräger innerhalb der Sammelschicht halten sollen

9. Fotodiode nach irgendeinem der Ansprüche 6 bis 8, **dadurch gekennzeichnet, dass** sie außerdem einen Resonator enthält, gebildet aus einer ersten und zweiten reflektierenden Fläche (7, 8) die jeweils auf einer Seite des Stapels angeordnet ist.

10. Fotodiode nach Anspruch 9, **dadurch gekennzeichnet, dass** die erste reflektierende Fläche (7) ein Metallspiegel ist und dass die zweite reflektierende Fläche (8) ein Bragg- Spiegel ist.

11. Fotodiode nach irgendeinem der Ansprüche 6 bis 9, **dadurch gekennzeichnet, dass** dieser Bereich (4) parallel in der ersten unteren Schicht (1) verläuft.

12. Fotodiode nach irgendeinem der Ansprüche 6 bis 10, **dadurch gekennzeichnet, dass** die zweite Schicht (3) von einer Passivierungsschicht (5) bedeckt ist.

13. Elektromagnetischer Strahlungsdetektor, umfassend mindestens eine Fotodiode nach irgendeinem der Ansprüche 6 bis 12.

## Claims

1. A method for manufacturing a photodiode capable of interacting with incident photons, consisting at least:
- in producing a stack of three semiconductor layers, each defining a semiconductor volume, and comprising an intermediate layer (2) placed between a first lower layer (1) and a second upper layer (3), the three layers (1, 2, 3) having a first conductivity type;
- in producing a semiconductor region (4) that gets through the volume of the second upper layer (3) and that at least partially gets through the volume of the intermediate layer (2) and that extends transversely relative to the planes of the three layers (1, 2, 3), said region (4) having a second conductivity type opposite to the first conductivity type so as to form a P-N junction with intermediate layer (2), and
- in producing a read plot (6) made of an electrically conducting material in contact with the semiconductor region (4) ;
***characterised:***
- **in that** the intermediate layer (2) is made of a semiconductor material having the second conductivity type;
- and **in that** the thickness of said intermediate layer (2) and the dopant concentrations of the first and second layers (1, 2, 3) and of the intermediate layer (2) are selected so that an inversion of the conductivity type of the intermediate layer (2) is obtained from the second conductivity type to the first conductivity type by the dopants of the first conductivity type that are present in the first and second layers (1, 3).

2. The method for manufacturing a photodiode as claimed in claim 1, ***characterised* in that** intermediate layer (2) has a thickness that is less than the respective thicknesses of the first and second layers (1, 3).

3. The method for manufacturing a photodiode as claimed in either claim 1 or 2, ***characterised* in that** the concentration of dopants of the second conductivity type in intermediate layer (2) is lower than the concentrations of dopants of the first conductivity type in the first and second layers (1, 3) respectively.

4. The method for manufacturing a photodiode as claimed in any of claims 1 to 3, ***characterised* in that** the semiconductor materials used to form the three layers (1, 2, 3) of the stack are alloys of cadmium, mercury and tellurium having the general formula CdₓHg₁₋ₓTe, where x is a value from 0 to 1 and represents the mole fraction of cadmium in the composition of the alloy.

5. The method for manufacturing a photodiode as claimed in claim 4, ***characterised* in that** the first and second layers (1, 3) each have:
- a concentration of dopants of the first conductivity type of 10¹⁵ cm⁻³ to 10¹⁷ cm⁻³;
- a thickness of 0.5 µm to 2 µm; and
- a mole fraction x of 0.3 to 0.8;
**and in that** the intermediate layer (2) has:
- a concentration of dopants of the second conductivity type of 10¹⁴ cm⁻³ to 10¹⁵ cm⁻³;
- a thickness of 0.1 µm to 1 µm; and
- a mole fraction x of 0.1 to 0.5, preferably a mole fraction of 0.2 to 0.3.

6. A photodiode capable of interacting with incident photons and at least comprising :
- a stack of three semiconductor layers, each defining a semiconductor volume, and comprising an intermediate layer (2) placed between a first lower layer (1) and a second upper layer (3), the three layers (1, 2, 3) having a first conductivity type;
- a semiconductor region (4) that gets through the volume of the second upper layer (3) and that at least partially gets through the volume of the intermediate layer (2) and that extends transversely relative to the planes of the three layers (1, 2, 3), said region (4) having a second conductivity type opposite to the first conductivity type so as to form a P-N junction with intermediate layer (2), and
- a read plot (6) made of an electrically conducting material in contact with the semiconductor region (4) ;
***characterised* in that** a concentration of charge carriers of the first conductivity type in the intermediate layer (2) is lower than the concentration of charge carriers of the first conductivity type in the first and second layers (1, 3).

7. The photodiode as claimed in claim 6, ***characterised:***
- **in that** the first layer (1) is an interaction layer designed to interact with incident photons so as to generate photocarriers;
- **in that** the intermediate layer (2) is a photocarrier collection layer and has a bandgap that is less than twice as wide as the respective bandgaps of the first and second layers (1, 3);
- and **in that** the second layer (3) is a confinement layer designed to confine photocarriers in the collection layer.

8. The photodiode as claimed in either claim 6 or 7, ***characterised:***
- **in that** intermediate layer (2) is both an interaction layer designed to interact with incident photons so as to generate photocarriers and a photocarrier collection layer, said intermediate layer (2) having a bandgap that is less than the width of the respective bandgaps of the first and second layers (1, 3);
- and **in that** the first and second layers (1, 3) are confinement layers designed to confine photocarriers in the collection layer.

9. The photodiode as claimed in any of claims 6 to 8, ***characterised* in that** it also comprises an optical cavity formed by first reflective surface (7) and second reflective surface (8) placed respectively either side of the stack.

10. The photodiode as claimed in claim 9, ***characterised* in that** the first reflective surface (7) is a metallic mirror and the second reflective surface (8) is a distributed Bragg reflector.

11. The photodiode as claimed in any of claims 6 to 9, ***characterised* in that** said region (4) extends partially into first lower layer (1).

12. The photodiode as claimed in any of claims 6 to 10, ***characterised* in that** the second layer (3) is covered by a passivation layer (5).

13. An electromagnetic radiation detector comprising at least one photodiode as claimed in any of claims 6 to 12.
